# NEUE EUROPÄISCHE PATENTSCHRIFT

(11) **EP 2 491 584 B2**
(45) Veröffentlichungstag und Bekanntmachung des Hinweises auf die Entscheidung über den Einspruch: **03.10.2018**
(45) Hinweis auf die Patenterteilung: 25.03.2015
(21) Anmeldenummer: 10739585.7
(22) Anmeldetag: 28.07.2010
(51) Int. Cl.: H01L 21/67, H01L 31/18, H01L 21/677

(54) **VERFAHREN UND VORRICHTUNG ZUR BEHANDLUNG EINER SUBSTRATOBERFLÄCHE EINES SUBSTRATS**
METHOD AND DEVICE FOR TREATING A SUBSTRATE SURFACE OF A SUBSTRATE
PROCÉDÉ ET DISPOSITIF DE TRAITEMENT DE LA SURFACE D'UN SUBSTRAT

(30) Priorität: 19.10.2009 DE 102009050845
(43) Veröffentlichungstag der Anmeldung: 29.08.2012
(73) Patentinhaber: Gebr. Schmid GmbH, 72250 Freudenstadt (DE)
(72) Erfinder: SCHMID, Christian, 72250 Freudenstadt (DE)
(74) Vertreter: Patentanwälte Ruff, Wilhelm, Beier, Dauster & Partner mbB
(86) Internationale Anmeldenummer: PCT/EP2010/060985
(87) Internationale Veröffentlichungsnummer: WO 2011/047894

(56) Entgegenhaltungen:
- DE-A1- 4 423 326
- DE-A1-102005 062 528
- DE-A1-102007 063 202
- JP-A- 2003 017 464

## Beschreibung

### Anwendungsgebiet und Stand der Technik

Die Erfindung betrifft ein Verfahren zur Behandlung einer Substratoberfläche gemäß dem Oberbegriff des Anspruchs 1 sowie eine zur Durchführung des Verfahrens geeignete Vorrichtung.

Aus der DE 10 2005 062 527 A1 sowie DE 10 2005 062 528 A1 sind Verfahren zur einseitigen Behandlung von flächigen Substraten bekannt, und zwar zur Behandlung der Substratunterseiten bzw. der nach unten weisenden Substratseiten. Bei der Anwendung dieses Verfahrens kann es trotz einer Absaugung unterhalb der Substrate zu einem leichten Angriff der Substratoberseite durch Reaktionsgase bzw. Ausgasungen aus dem Prozessmedium kommen, unter Umständen auch durch direkten Kontakt. Außerdem kann abhängig von der Transportgeschwindigkeit der Substrate, der Mischung des Prozessmediums bzw. der Chemie und dem Zustand der Substratoberflächen ein unerwünschter Randumgriff des Prozessmediums auftreten. Dadurch kann die Substratoberseite angegriffen sowie optisch oder, was noch schlimmer ist, funktional beeinträchtigt werden.

Weiter ist aus der EP 1 037 261 A2 eine Vorrichtung und ein Verfahren bekannt, bei dem die Substratunterseite eines flachen Substrats mit einem Prozessmedium mit abtragender bzw. ätzender Wirkung behandelt wird. Dabei werden die Substrate horizontal liegend von unten mit dem Prozessmedium behandelt. Gleichzeitig wird die nach oben weisende Substratoberseite mit einer Schutzflüssigkeit flächig benetzt oder bedeckt als Schutz gegen ein Einwirken des Prozessmediums oder seiner Ausgasungen auf die mit dem Prozessmedium nicht behandelte Substratoberseite.

Die beiden Offenlegungsschriften DE 10 2007 026 081 A1 und DE 10 2007 063 202 A1 zeigen Verfahren und Vorrichtungen zur Behandlung von Silizium-Wafern. Bei den entsprechenden Vorrichtungen ist oberhalb einer Durchlauf- oder Transportbahn für Substrate (Silizium-Wafer), die zur Behandlung der Substratunterseite mit einem Prozessmedium über einem Becken mit dem entsprechenden Prozessmedium darin transportiert werden, mindestens eine Auftragvorrichtung zum Aufbringen des Prozessmediums oder einer Spülflüssigkeit vorgesehen.

### Aufgabe und Lösung

Der Erfindung liegt die Aufgabe zugrunde, ein eingangs genanntes Verfahren sowie eine entsprechende Vorrichtung zu schaffen, mit denen Probleme des Standes der Technik beseitigt werden können und insbesondere eine Möglichkeit geschaffen wird, eine nach oben weisende Substratoberseite des Substrats vor unerwünschter und schädlicher Einwirkung des Prozessmediums, insbesondere in ausgegaster Form, zu verhindern.

Gelöst wird diese Aufgabe durch ein Verfahren mit den Merkmalen des Anspruchs 1 sowie eine Vorrichtung mit den Merkmalen des Anspruchs 11. Vorteilhafte sowie bevorzugte Ausgestaltungen der Erfindung sind Gegenstand der weiteren Ansprüche und werden im Folgenden näher erläutert. Manche der nachfolgenden Merkmale werden nur für das Verfahren oder nur für die Vorrichtung beschrieben. Sie sollen jedoch unabhängig davon sowohl für das Verfahren als auch für die Vorrichtung gelten können. Der Wortlaut der Ansprüche wird durch ausdrückliche Bezugnahme zum Inhalt der Beschreibung gemacht.

Es ist vorgesehen, dass die Substratoberfläche bzw. die Substratunterseite mit einem üblicherweise flüssigen Prozessmedium behandelt wird. Das Prozessmedium weist eine abtragende bzw. ätzende Wirkung auf die Substratoberfläche auf, beispielsweise zum Polierätzen oder Kantenisolieren eines Siliziumsubstrats für eine Solarzelle. Dabei werden die Substrate horizontal liegend von unten mit dem Prozessmedium benetzt, was auf verschiedene, aus dem Stand der Technik bekannte Art und Weise erfolgen kann. Die nach oben weisende bzw. gerichtete Substratoberseite wird mit Wasser oder einer anderen entsprechenden Schutzflüssigkeit großflächig bzw. vorteilhaft sogar vollflächig benetzt oder bedeckt. Dies wirkt als Schutz gegen Einwirken bzw. Gelangen des Prozessmediums oder Ausgasungen davon auf die Substratoberseite, es kann also sozusagen davon ferngehalten werden. Das Wasser oder die Schutzflüssigkeit bilden also eine Schutzschicht auf der Substratoberseite, so dass diese von dem Prozessmedium nicht beschädigt werden kann. Der Vorteil einer Flüssigkeit wie Wasser oder einer sonstigen Schutzflüssigkeit als Schutzschicht bzw. Schutzmedium liegt darin, dass eine Flüssigkeit leicht aufgebracht und leicht wieder entfernt werden kann und keine mechanische Beeinträchtigung der Substratoberseite bewirkt, also kein Verkratzen odgl.. Des weiteren kann das Wasser oder allgemein die Schutzflüssigkeit vorteilhaft so gewählt werden, dass keinerlei Reaktion mit der Substratoberseite erfolgt oder eine sonstige negative Beeinträchtigung. Schließlich ist es noch möglich, dass das Wasser bzw. die Schutzflüssigkeit derart mit der Wahl des Prozessmediums abgestimmt ist, dass von der Substratoberseite herablaufendes Wasser bzw. eine entsprechende Schutzflüssigkeit in das Prozessmedium gelangen kann und dieses möglicherweise zwar verdünnt. Aufgrund der geringen Menge wird aber nur eine unwesentlich und ansonsten keine negative Beeinträchtigung der Wirkung, in der Regel der Ätzwirkung, des Prozessmediums bewirkt. Hierzu wird nachfolgend noch mehr ausgeführt.

Es ist erfindungsgemäß vorgesehen, die Schutzflüssigkeit auf die Substratoberseite zu bringen, bevor die Substratunterseite mit dem Prozessmedium benetzt wird. Insbesondere erfolgt das Aufbringen der Schutzflüssigkeit sogar, bevor das Substrat über ein Becken mit dem Prozessmedium darin bewegt wird, also zeitlich deutlich davor bzw. auf einer Transportbahn etwa einen halben Meter oder weniger davor. Dadurch kann erreicht werden, dass herablaufende Schutzflüssigkeit gar nicht erst in das Becken mit dem Prozessmedium darin gelangen kann. Für die übliche Zeit von einigen Sekunden oder wenigen Minuten, die die Behandlung mit dem Prozessmedium über dem Becken dauert, kann ein einmaliges Aufbringen von Schutzflüssigkeit auf die Substratoberseite ausreichen.

Alternativ oder zusätzlich kann das erfindungsgemäße Verfahren so ausgestaltet sein, dass die Schutzflüssigkeit derart gesteuert auf die Substratoberseite aufgebracht wird, dass sie ausschließlich auf der Substratoberseite ist. Dies ist möglich durch Starten des Aufbringens erst dann, wenn sich ein Substrat unter einer Auftragvorrichtung befindet. In ähnlicher Weise wird dann gestoppt, wenn sich das Substrat noch unter der Auftragvorrichtung befindet. Vorteilhaft kann mittels Substrat-Sensoren die Position bzw. Lage eines herangeführten Substrats ermittelt werden und in Abhängigkeit davon die Auftragvorrichtung angesteuert werden. Alternativ kann aus dem Aufbringen der Substrate deren Position berechnet werden und dies an eine Steuerung der Anlage für die Auftragdüsen gegeben werden. So kann eine Schicht der Schutzflüssigkeit gebildet werden, die nicht an der Kante der Substrate herunterläuft, so dass diese mit dem Prozessmedium behandelt werden können.

In weiterer Ausgestaltung der Erfindung wird die Schutzflüssigkeit im Durchlaufverfahren auf die bewegten Substrate bzw. deren Substratoberseiten aufgebracht. Dies kann vorteilhaft mit einer feststehenden Auftragvorrichtung in Form von Sprühdüsen oder Sprührohren erfolgen, vorteilhaft jedoch mit wenig Druck, beispielsweise auch mittels Schwallrohren. Eine Dosierung ist für eine gewünschte Flüssigkeitsmenge auf der Substratoberseite bzw. Dicke eines Flüssigkeitsfilms leicht einzustellen.

Auch wenn es in manchen Fällen ausreichen mag, die Schutzflüssigkeit nur einmal auf die Substratoberseite aufzubringen, so kann vorteilhaft vorgesehen sein, die Schutzflüssigkeit mehrfach bzw. mit zeitlichen Abständen auf die Substratoberseite aufzubringen bzw. den dadurch gebildeten Schutzfilm zu erneuern. Dies kann beispielsweise auch dadurch erfolgen, dass die Schutzflüssigkeit aufgebracht wird, während die Substrate über dem Becken mit Prozessmedium darin laufen. Entweder kann hier ein Aufbringen sehr genau erfolgen, so dass möglichst wenig Schutzflüssigkeit in das Becken gelangt, oder es kann ein spezieller abgegrenzter Bereich vorgesehen sein oder die Substrate werden noch einmal herausgefahren, was in der Regel jedoch zu aufwendig ist.

Alternativ dazu kann die Schutzflüssigkeit nur ein einziges Mal auf die Substratoberseite aufgebracht werden, und zwar insbesondere bevor sich das Substrat über dem Becken mit dem Prozessmedium darin befindet.

Mit entsprechend ausgebildeten vorgenannten Auftragvorrichtungen kann in einer Ausgestaltung der Erfindung die Schutzflüssigkeit mit flächig verteiltem Profil auf die Substratoberseite aufgebracht werden. Dazu können entsprechende Auftragvorrichtungen so ausgebildet sein, beispielsweise als Sprühdüsen, dass sie einen flächig verteilten Sprühnebel oder als Schwallrohre einen brieten Wasserschleier erzeugen. Dies ist zum einen dafür geeignet, dass die Substratoberseiten vor dem Bewegen über das Becken mit Prozessmedium mit der Schutzflüssigkeit bedeckt werden. Des weiteren wird ein leichter Auftrag von Schutzflüssigkeit ermöglicht, wenn diese keine negative Zusammenwirkung mit dem Prozessmedium aufweist.

Alternativ zu einem flächigen Auftrag der Schutzflüssigkeit auf die Substratoberseite kann dies mit flächig verteiltem Profil bzw. punktuell erfolgen. Dies bedeutet also, dass aus einer oder wenigen Auftragvorrichtungen die Schutzflüssigkeit relativ punktuell auf die Substratoberseite gespritzt oder getropft wird und dann zerfließt. So kann letztlich die Substratoberfläche großflächig bzw. vollflächig bedeckt werden, wobei bei bekannten Eigenschaften der Substratoberseite, der Temperatur sowie der Eigenschaften der Schutzflüssigkeit deren Menge relativ genau so bestimmt werden kann, dass nur ein geringer Anteil über das Substrat überläuft und nach unten in das Prozessmedium gelangen kann.

Bei dem Verfahren kann vorgesehen sein, dass bei dem Benetzen bzw. Behandeln der Substratunterseite mit dem Prozessmedium eine exotherme Reaktion stattfindet mit einer Temperaturerhöhung von mindestens 10°C. Dann kann vorteilhaft eine relativ dicke Schicht von Schutzflüssigkeit auf die Substratoberseite aufgebracht werden, beispielsweise mit mehr als 0,5mm oder mehr als 1mm Dicke, bis zu 1,5mm bei Wasser und bei Schutzflüssigkeiten mit höherer Viskosität noch dicker. Dadurch kann ein Großteil der Schutzflüssigkeit verdampfen durch die Temperaturerhöhung und immer noch eine ausreichend wirksame Schutzschicht übrig bleiben.

Alternativ kann eine Temperaturerhöhung bei der Behandlung der Substratunterseite mit dem Prozessmedium unterbleiben. Dann reicht eine wesentlich geringere Schichtdicke für die Schutzflüssigkeit auf der Substratoberseite, beispielsweise weniger als 0,2mm oder sogar weniger als 0,05mm, eben nur ein dünner Film. Sie kann aber auch in diesem Fall eine vorgenannte Dicke haben.

In weiterer Ausgestaltung der Erfindung kann vorgesehen sein, dass die Substratunterseite beim Behandeln einen Flüssigkeitsspiegel von Prozessmedium in einem Becken berührt, ohne dass die Substrate tiefer eintauchen. Dann können sie sozusagen auf der Oberfläche des Prozessmediums schwimmen. Hier kann ohne Schutzflüssigkeit die Gefahr gegeben sein, dass Prozessmedium an den Kanten des Substrats anhaftet und möglicherweise sogar auf die Substratoberseite gelangt mit entsprechenden negativen Folgen. Alternativ kann ein Besprühen der Substratunterseite mit dem Prozessmedium erfolgen, wobei hier die Gefahr sogar noch größer ist, dass das nach oben gesprühte Prozessmedium an den Außenkanten der Substrate vorbei nach oben gelangt und sich dann zumindest in den Randbereichen auf den Substratoberseiten niederschlägt. Bei einem solchen Besprühen der Substratunterseiten mit dem Prozessmedium von unten ist es noch unkritischer, wenn zuviel aufgebrachte Schutzflüssigkeit von dem Substrat herabtropft, da sie dann nicht zwingend mit dem Prozessmedium vermischt wird, welches gegen die Substratunterseite gesprüht wird. Möglicherweise gelangt die Schutzflüssigkeit dann zwar in ein gemeinsames Auffangbecken, kann dort aber möglicherweise abgetrennt werden oder aber durch entsprechende Behandlung kann das Prozessmedium wieder mit der gewünschten Konzentration vorliegen.

Nach dem Behandeln der Substrate mit dem Prozessmedium können diese Substrate abgespült werden. Dabei kann vorgesehen sein, dass auch die Schutzflüssigkeit von der Substratoberseite abgespült bzw. entfernt wird.

Des weiteren können hier gemäß einem weiteren Aspekt der Erfindung auch solche Substrate sozusagen bei einem Ätzvorgang ihrer Substratunterseite vor Gelangen der Ätzwirkung auf die Substratoberseite geschützt werden, die durchgebohrt sind bzw. Durchbrüche aufweisen. Dadurch wird vor allem ein Bereich rund um die Durchbrüche gefährdet. Ein Substrat kann also nicht nur vor einem Randumgriff des Prozessmediums oder einem Niederschlag von oben geschützt werden, sondern auch vor einem Aufsteigen des Prozessmediums durch Durchbrüche, beispielsweise aufgrund Kapillarwirkung.

Als Schutzflüssigkeit bietet sich neben Wasser bzw. reinem Wasser eine an, die eine höhere Viskosität aufweist. Ein Beispiel hierfür ist PEG mit einer Viskosität mit Faktor 2 bis mehr als 3 über derjenigen von Wasser, oder beispielsweise auch bis zu Faktor 3,8 bei Phosphorsäure als Schutzflüssigkeit. Die Phosphorsäure kann auch speziell verhindern, dass aufgrund des Konzentrationsgefälles beispielsweise eine Ätzlösung mit Phosphorsäure und HF bei durchbohrten Substraten nicht nur durch die Kapillarwirkung nach oben gezogen wird, sondern auch aufgrund des Konzentrationsgefälles, wie es bei Wasser vorhanden wäre.

Andere Schutzflüssigkeiten können eine noch viel höhere Viskosität haben für noch verbesserte Schutzwirkung bzw. Schichtdicke. Durch die höhere Viskosität wird erreicht, dass die Schutzflüssigkeit sozusagen etwas zähflüssiger ist und nicht so leicht von der Substratoberseite abläuft.

Es sind vorteilhaft mehrere Auftragvorrichtungen nebeneinander vorgesehen sind in einer Richtung etwa quer zur Durchlaufbahn der Substrate. Die Substrate können vorteilhaft hintereinander in Reihen auf die Durchlaufbahn gebracht werden und jeweils genau unter einer Auftragvorrichtung durchlaufen.

Bei der erfindungsgemäßen Vorrichtung ist eben vorgesehen, dass oberhalb einer Durchlaufbahn für die Substrate Auftragvorrichtungen vorgesehen sind, vorteilhaft in Form von Düsen. Sie können entweder ausschließlich vor dem Becken mit dem Prozessmedium darin angeordnet sein, über dem Becken oder sowohl vor dem Becken als auch über dem Becken. Die Auftragvorrichtungen sind vorteilhaft so ausgebildet, dass sie an Größe, Anzahl der Substrate nebeneinander sowie Durchlaufgeschwindigkeit so angepasst werden können, dass nur in gewünschtem Ausmaß Schutzflüssigkeit auf die Substratoberseiten ausgebracht wird und nicht oder nur unwesentlich zuviel.

Erfindungsgemäß ist mindestens eine Auftragvorrichtung vor dem Becken mit dem Prozessmedium darin angeordnet, wobei besonders vorteilhaft eine einzige Reihe von Auftragvorrichtungen quer zur Durchlaufbahn für die Substrate vorgesehen ist. Die Auftragvorrichtungen sind dabei voneinander beabstandet, wobei insbesondere der Abstand mindestens eine Substratbreite beträgt.

Zur Versorgung der Auftragvorrichtungen können sie an einen Vorratstank angeschlossen sein, der höher angeordnet ist als die Auftragvorrichtungen. So kann einfach durch Schwerkraft alleine der Zufluss von Schutzflüssigkeit zu den Auftragvorrichtungen mit gleichbleibendem Druck erreicht werden.

In Ausgestaltung der Erfindung können entlang der Durchlaufbahn gesehen vor den Auftragvorrichtungen Substrat-Sensoren vorgesehen sein zum Erkennen eines heran bewegten Substrates sowie zum Erkennen eines vorbei bewegten Substrates. Vorteilhaft sind es optische Sensoren.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine seitliche Schnittdarstellung einer erfindungsgemäßen Anlage zur Behandlung von Substratunterseiten, während auf den Substratoberseiten Wasser als Schutzfilm aufgebracht ist,
- Fig. 2: eine vergrößerte Darstellung aus Fig. 1 und
- Fig. 3: eine Draufsicht auf eine alternative erfindungsgemäße Anlage mit weniger Auftragdüsen und Substrat-Sensoren davor.

### Detaillierte Beschreibung der Ausführungsbeispiele

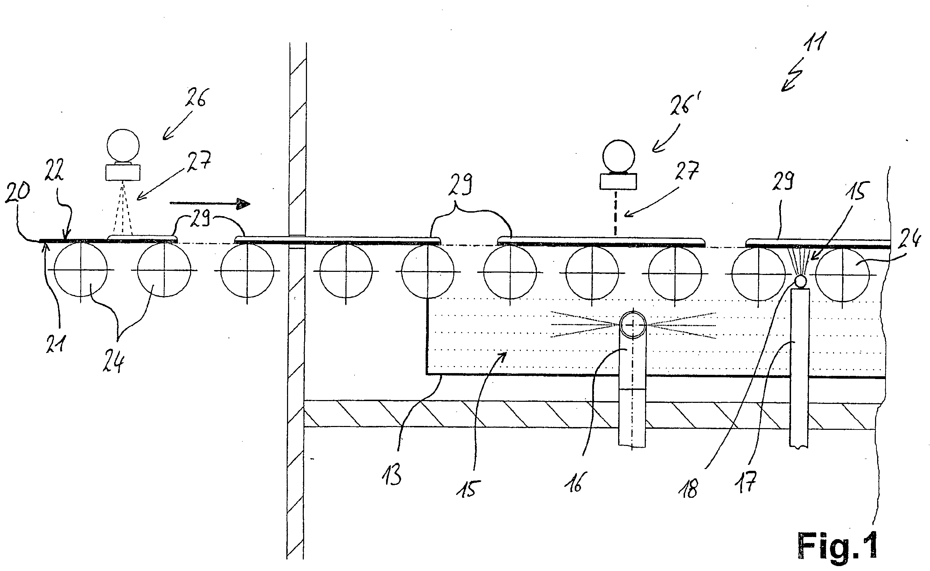

In Fig. 1 ist als erfindungsgemäße Vorrichtung eine Anlage 11 dargestellt im seitlichen Schnitt mit einem Becken 13, in dem sich Ätzlösung 15 als Prozessmedium befindet. Von links werden Substrate 20 mit ihrer Substratunterseite 21 nach unten und einer Substratoberseite 22 nach oben weisend auf einer Durchlaufbahn aus Transportrollen 24 nach rechts transportiert. Sie gelangen dann auf den Transportrollen 24 über das Becken 13. Wie aus den eingangs beschriebenen DE 10 2005 062 527 A1 sowie DE 10 2005 062 528 A1 bekannt ist, wird gemäß einer ersten Möglichkeit mittels der Transportrollen 24, die mit ihrem unteren Bereich in die Ätzlösung 15 reichen, diese Ätzlösung 15 an die Substratunterseiten 21 gebracht werden. Über ein Zufuhrrohr 16 wird frische bzw. aufbereitete Ätzlösung 15 in das Becken 13 gebracht. Alternativ oder zusätzlich zu einer Benetzung der Substratunterseiten 21 mittels der Transportrollen 24 kann ein Sprührohr 17 vorgesehen sein mit einer nach oben weisenden Sprühdüse 18. Damit kann Ätzlösung 15 auf die Substratunterseiten 21 aufgesprüht werden.

Des weiteren können noch entsprechend der DE 10 2005 062 527 A1 Mittel zum Absaugen von Gas, welches aus der Ätzlösung 15 ausgast, oberhalb der Oberfläche der Ätzlösung und unterhalb der Transportebene der Substrate vorgesehen sein.

Deutlich vor dem Einfahren der Substrate 20 über das Becken 13 werden sie von einer darüber angeordneten Auftragdüse 26 mit Wasser besprüht, welches auf der Substratoberseite 22 einen Schutzfilm 29 bildet. Dabei kann das Besprühen mit Wasser 27 vorteilhaft flächig erfolgen bzw. die Auftragdüse 26 kann sich über die gesamte Breite des Substrats 20 erstrecken. Anstelle der Auftragdüse, deren Düsen einen Abstand von einigen cm zueinander haben können, kann auch ein genanntes Schwallrohr mit Bohrungen oder Schlitzen verwendet werden. Beim Durchlauf des Substrats 20 unter der Auftragdüse 26 wird dann die gesamte Substratoberseite 22 mit Wasser 27 besprüht bzw. benetzt und so ein vollflächiger Schutzfilm 29 gebildet. Der Vorteil des Besprühens, insbesondere wenn es vollflächig erfolgt, liegt hier darin, dass dann sichergestellt ist, dass die gesamte Substratoberseite 22 von dem Schutzfilm 29 bedeckt ist. Soll das Wasser 27 lediglich von einer einzigen Stelle aus verlaufen, so könnte es passieren, dass beispielsweise verschmutzte Bereiche odgl. an der Substratoberseite 22 nicht benetzt bzw. bedeckt werden und somit nicht geschützt sind. Vorteilhaft werden pro Substrat drei Löcher an der Auftragdüse 26 bzw. am Schwallrohr vorgesehen.

Wird nun auf bekannte Art und Weise über dem Becken 13 die Ätzlösung 15 an die Substratunterseite 21 gebracht, so sind die Substratoberseiten 22 noch mit dem Schutzfilm 29 bedeckt und somit vor Einwirken durch die Ätzlösung 15 geschützt. Um zu verhindern, dass Bereiche der Substratoberseite 22 frei liegen bzw. hier kein Schutzfilm 29 mehr vorhanden ist, beispielsweise weil das Wasser 27 abgelaufen ist oder durch hohe Temperatur beim Ätzen zum Teil verdampft ist, kann mittels einer weiteren Auftragdüse 26' wieder Wasser 27 aufgebracht werden. Einerseits kann diese zusätzliche Auftragdüse 26' ausgebildet sein wie die Auftragdüse 26 vor dem Becken 13, also einen eher flächigen, relativ feinen Sprühnebel erzeugen bzw. einen Flächenbereich der Substratoberseite 22 bedecken.

Wird die Auftragdüse 26' aber so angeordnet, dass bei dem durchzuführenden Ätzverfahren der Schutzfilm 29 möglicherweise schon stellenweise dünn wird aber noch vorhanden ist, so reicht es, wenn überhaupt in irgend einer Form Wasser 27 nachgeführt wird. So kann verhindert werden, dass der Schutzfilm 29 sozusagen zu dünn wird bzw. stellenweise wegfällt. Der Vorteil eines solchen eher punktförmigen Aufbringens von Wasser 27 auf die Substratoberseite 22 gemäß einer zweiten Möglichkeit besteht darin, dass nicht gesprüht werden muss, weil bei einem solchen Sprühen zwangsläufig etwas von dem Wasser 27 an dem Substrat 20 vorbeigeht in das Becken 13. Ein Herabtropfen an den Außenkanten des Substrats 20 kann aber nicht verhindert werden. Da allerdings nur sehr geringe Menge heruntertropfen bzw. das Heruntertropfen von nur sehr geringen Mengen nicht vermieden werden kann, wird hierdurch kaum eine Verwässerung der Ätzlösung 13 stattfinden und somit die Ätzwirkung kaum beeinträchtigt werden. Vor allem wenn die Ätzlösung 15 mit dem Sprührohr 17 samt Sprühdüse 18 aufgebracht wird, kann sie so zugeführt werden, dass sie nicht durch Wasser 27 verdünnt wird.

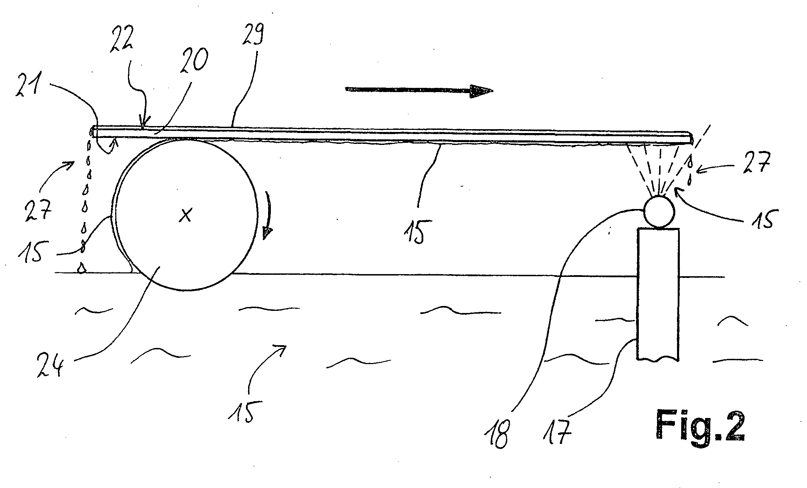

In der vergrößerten Darstellung in Fig. 2 ist zum einen zu erkennen, wie das Aufbringen der Ätzlösung 15 mittels der linken Transportrolle 24 auf die Substratunterseite 21 erfolgt entsprechend der DE 10 2005 062 528 A1. Dadurch wird eine Art Schicht mit Ätzlösung 15 an der Substratunterseite 21 gebildet, die dort den Ätzvorgang bewirkt. Rechts ist ein Sprührohr 17 mit einer Sprühdüse 18 dargestellt, welche Ätzlösung 15 auf die Substratunterseite 21 sprüht. Dabei ist rechts dargestellt, wie etwas von der aufgesprühten Ätzlösung 15 an dem Substrat 20 vorbeigesprüht wird und möglicherweise auf eine Substratoberseite 22 eines rechts daneben angeordneten bzw. sich bewegenden, benachbarten Substrats fallen kann. Der auch auf diesem Substrat vorhandene Schutzfilm aus Wasser kann aber eine negative Beeinträchtigung vermeiden.

Des weiteren ist dargestellt, wie links und rechts von dem Substrat 20 etwas Wasser 27 herabtropft. Dieses Wasser 27 gelangt in die Ätzlösung 15 im Becken 13 und verdünnt diese zwar etwas. Da die Wassermenge aber sehr gering sein kann, insbesondere im Verhältnis zu der Menge an Ätzlösung, ist dieser Umstand nahezu vernachlässigbar bzw. kann bei Anmischen der Ätzlösung 15 entsprechend berücksichtigt werden.

Des weiteren ist aus Fig. 2 zu ersehen, dass auch ein Aufbringen von relativ viel Wasser 27 als Schutzfilm 29 auf die Substratoberseite 22 nicht unbedingt schädlich sein muss, da die an die Substratunterseite 21 gebrachte Ätzlösung 15 nicht zwingend direkt mit diesem Wasser 27 vermischt wird.

Möglicherweise sind die Kantenflächen des Substrats 20 ohne Schutzfilm 29 bzw., wenn nicht gerade Wasser 27 über sie überläuft und sie bedeckt, nicht geschützt. An den Kanten jedoch ist die Einwirkung bzw. ein durch die Ätzlösung 15 verursachter Schaden sehr gering bzw. vernachlässigbar, so dass diese Kantenflächen nicht geschützt werden müssen.

Anstelle von Wasser kann eine andere Flüssigkeit für den Schutzfilm verwendet werden, beispielsweise PEG bzw. Polyethylenglykol. Dieses ist chemisch inert und reagiert weder mit dem Substrat 20 auf ungewünschte Weise, noch beeinträchtigt es die Wirkung der Ätzlösung 15. Es kann auch Phosphorsäure als Schutzflüssigkeit aufgebracht werden, die ein Substrat wie beispielsweise einen Siliziumwafer für Solarzellen nicht negativ beeinträchtigt. Deren höhere Viskosität ist vor allem für den Fall gut, wenn die Substrate die vorbeschriebenen Durchbrüche bzw. Durchbohrungen aufweisen.

Die genaue Ausbildung der Auftragdüsen bzw. Schwallrohre, insbesondere ob und wie viele davon über dem Becken 13 mit Ätzlösung 15 angeordnet sind, sowie deren genaue örtliche Anordnung kann an den jeweiligen Ätzprozess bzw. Behandlungsschritt angepasst werden. Hierfür können beispielsweise auch bewegbare Auftragsdüsen bzw. Schwallrohre vorgesehen sein oder es werden jeweils nur wenige eingesetzt von einer Vielzahl, die grundsätzlich baulich vorgesehen ist.

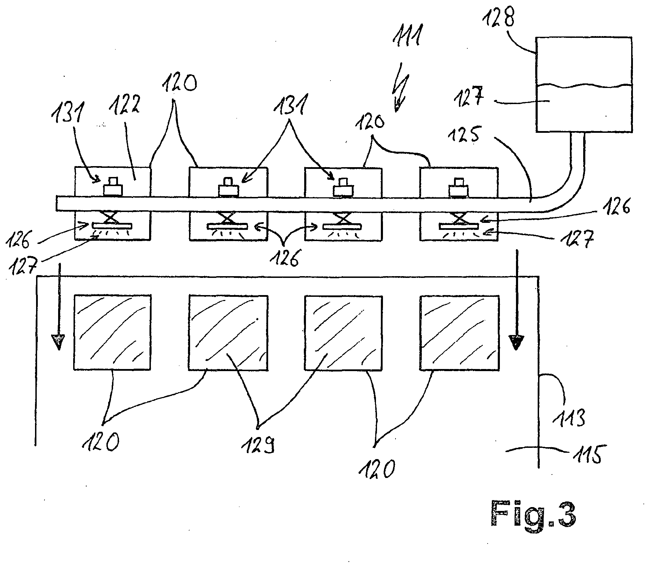

In Fig. 3 ist eine Draufsicht auf eine alternative Anlage 111 dargestellt. Vor einem Becken 113 mit Ätzlösung 115 darin laufen vier Reihen von Substraten 120 auf einer Durchlaufbahn, die von nicht dargestellten Transportrollen ähnlich von Fig. 1 gebildet wird. Es können auch weniger oder mehr Reihen sein, beispielsweise sechs. Vor dem Becken 113 verläuft ein Düsenrohr 125 quer zur Durchlaufbahn und weist vier Auftragdüsen 126 auf. Diese weisen je ein Magnetventil und Düsenöffnungen auf, die dem Fachmann aber bekannt sind und hier nicht weiter dargestellt werden müssen. Die Breite der Auftragdüsen 126 ist geringer als die Breite eines Substrats 120. Der Abstand der Auftragdüsen 126 zueinander ist es auch, das muss aber nicht so sein.

Das Düsenrohr 125 ist flüssigkeitsleitend an einen Vorratstank 128 angeschlossen, in dem sich Wasser 127 zum Aufbringen auf die Substratoberseiten 122 befindet. Durch eine Anordnung des Vorratstanks 128 auf einem Höhenniveau oberhalb der Auftragdüsen 126 strömt das Wasser 127 selbsttätig bzw. von allein heraus und durch Öffnen oder Schließen der Magnetventile der Auftragdüsen 126 ändert sich der Wasserfluss bzw. die Wassermenge ist jeweils gleich. Druckschwankungen können nämlich vermieden werden, vor allem wenn die Magnetventile der Auftragdüsen 126 versetzt zueinander betätigt werden.

Des weiteren sind Substrat-Sensoren 131 vorgesehen, die hier beispielhaft an dem Düsenrohr 125 befestigt sind, aber auch separat davon gelagert sein könnten. Die Substrat-Sensoren 131 erkennen das Ankommen, Durchlaufen und Vorbeifahren der Substrate 120. Es können beispielsweise optische Sensoren sein, insbesondere auch als Lichtschranke, die eben das Heranfahren einer Vorderkante eines Substrats 120 erkennen sowie auch, wenn dann die Hinterkante vorbeigefahren ist. Eine nicht dargestellte Steuerung der Anlage 111 empfängt die Signale der Substrat-Sensoren 131 und kann dann die Auftragdüsen 126 bzw. deren Ventile so betätigen, dass ein Austrag von Wasser 127 auf die Substratoberseiten 122 erst dann erfolgt, wenn sich diese darunter befinden. So kann sichergestellt werden, dass das Wasser 127 tatsächlich nur auf die Substratoberseite 122 aufgebracht wird. Dies hat den Sinn, dass dann die Wassermenge so begrenzt werden kann, dass sich zwar der flächig voll verteilte Schutzfilm 129 ausbildet, aber kein Wasser über die seitlichen Kanten überläuft und herunter läuft. Zum einen wird so nachfolgend über dem Becken 113 die Ätzlösung 115 nicht mit Wasser vermischt bzw. verdünnt. Zum anderen kann, da die Seitenkanten des Substrats 120 frei sind, auch dort die Ätzlösung 115 wirken. Aufgrund der Oberflächenspannung des Wassers bildet sich dann das bereits in Fig. 1 und 2 dargestellte Kissen bzw. die Schicht aus Wasser 127. Unter Umständen kann auch ein Substrat 120 mit einer hydrophilen Substratoberseite 122 verwendet werden, wodurch sich dieser Effekt noch steigern lässt. Es wird aber nur ein einziges Mal das Wasser 127 auf die Substratoberseiten 122 aufgebracht.

In einer leicht vorstellbaren alternativen Ausgestaltung der Erfindung wird auf die Substrat-Sensoren 131 verzichtet und eine Steuerung der Anlage 111 kann aus Daten einer vorgeschalteten Zuliefereinrichtung für Substrate berechnen, wann sich diese jeweils genau unter den Auftragdüsen 126 befinden. So kann ebenfalls ein zielgerichtetes und genau gegrenztes Aufbringen von Wasser 127 auf die Substratoberseiten 122 erfolgen. Ebenso könnten deutlich mehr Auftragdüsen 126 und Substrat-Sensoren 131 nebeneinander vorgesehen sein, die es dann ermöglichen, dass auch bei unterschiedlich platzierten Substraten genau auf die Substratoberseiten das Wasser aufzubringen mittels der jeweils am besten mittig darüber platzierten Auftragdüse.

## Patentansprüche

1. Verfahren zur Behandlung einer Substratoberfläche eines flachen Substrats mit einem Prozessmedium an der Substratunterseite, wobei das Prozessmedium eine abtragende bzw. ätzende Wirkung auf die Substratoberfläche aufweist, und wobei die Substrate horizontal liegend von unten mit dem Prozessmedium benetzt werden und die nach oben weisende Substratoberseite durch mindestens eine Auftragvorrichtung mit Wasser oder einer entsprechenden Schutzflüssigkeit großflächig bzw. vollflächig benetzt oder bedeckt wird als Schutz gegen Einwirken oder Gelangen des Prozessmediums oder seiner Ausgasungen auf die Substratoberseite, **dadurch gekennzeichnet, dass**
- die Schutzflüssigkeit auf die Substratoberseite gebracht wird, bevor die Substratunterseite mit dem Prozessmedium benetzt wird, insbesondere bevor das Substrat über ein Becken mit dem Prozessmedium darin bewegt wird, und/oder
- die Schutzflüssigkeit derart gesteuert auf die Substratoberseite aufgebracht wird, dass sie ausschließlich auf die Substratoberseite aufgebracht wird durch Starten des Aufbringens erst dann, wenn sich ein Substrat unter einer Auftragvorrichtung befindet, und durch Stoppen dann, wenn sich das Substrat noch unter der Auftragvorrichtung befindet.

2. Verfahren nach Anspruch 1, **dadurch gekennzeichnet, dass** die Schutzflüssigkeit im Durchlaufverfahren auf die Substratoberseiten aufgebracht wird.

3. Verfahren nach Anspruch 1 oder Anspruch 2, **dadurch gekennzeichnet, dass** die Schutzflüssigkeit mehrfach mit zeitlichen Abständen auf die Substratoberseite aufgebracht wird.

4. Verfahren nach Anspruch 1 oder Anspruch 2, **dadurch gekennzeichnet, dass** die Schutzflüssigkeit ein einziges Mal auf die Substratoberseite aufgebracht wird.

5. Verfahren nach einem der vorhergehenden Ansprüche, **dadurch gekennzeichnet, dass** mittels Substrat-Sensoren die Position bzw. Lage eines herangeführten Substrats ermittelt wird und in Abhängigkeit davon die Auftragvorrichtung angesteuert wird.

6. Verfahren nach einem der vorhergehenden Ansprüche, **dadurch gekennzeichnet, dass**
- die Schutzflüssigkeit mit flächig verteiltem Profil auf die Substratoberseite aufgebracht wird, insbesondere mittels Sprühdüsen, die zur Erzeugung eines flächig verteilten Sprühnebels ausgebildet sind, oder
- die Schutzflüssigkeit punktuell auf die Substratoberseite aufgebracht wird zum anschließenden Zerfließen, um die Substratoberfläche großflächig bzw. vollflächig zu bedecken.

7. Verfahren nach einem der vorhergehenden Ansprüche, **dadurch gekennzeichnet, dass**
- die Substratunterseite einen Flüssigkeitsspiegel von Prozessmedium in einem Becken mit dem Prozessmedium darin berührt ohne tieferes Eintauchen der Substrate und/oder
- die Substrate nach der Behandlung mit dem Prozessmedium abgespült werden, insbesondere auch die Schutzflüssigkeit von der Substratoberseite abgespült bzw. entfernt wird.

8. Verfahren nach einem der vorhergehenden Ansprüche, **dadurch gekennzeichnet, dass** die Schutzflüssigkeit eine höhere Viskosität als Wasser aufweist, insbesondere PEG oder Phosphorsäure ist.

9. Verfahren nach einem der vorhergehenden Ansprüche, **dadurch gekennzeichnet, dass** Substrate behandelt werden, die durchgebohrt sind bzw. Durchbrüche aufweisen, wobei vorzugsweise eine Schutzflüssigkeit nach Anspruch 8 mit einer höherer Viskosität als Wasser verwendet wird.

10. Verfahren nach einem der vorhergehenden Ansprüche, **dadurch gekennzeichnet, dass** mehrere Auftragvorrichtungen nebeneinander vorgesehen sind in einer Richtung etwa quer zur Durchlaufbahn der Substrate und die Substrate hintereinander in Reihen auf die Durchlaufbahn gebracht werden und jeweils genau unter einer Auftragvorrichtung durchlaufen.

11. Vorrichtung zur Durchführung des Verfahrens nach einem der vorhergehenden Ansprüche, wobei oberhalb einer Durchlaufbahn für Substrate, die zur Behandlung der Substratunterseite mit einem Prozessmedium über einem Becken mit dem Prozessmedium darin transportiert werden, mindestens eine Auftragvorrichtung vorgesehen ist zum Aufbringen von Wasser bzw. Schutzflüssigkeit auf die nach oben weisende Substratoberseite, **dadurch gekennzeichnet, dass** mindestens eine Auftragvorrichtung vor dem Becken mit dem Prozessmedium darin angeordnet ist

12. Vorrichtung nach Anspruch 11, **dadurch gekennzeichnet, dass** eine Reihe von Auftragvorrichtungen quer zur Durchlaufbahn für die Substrate vorgesehen ist mit zueinander beabstandeten Auftragvorrichtungen, wobei insbesondere deren Abstand mindestens eine Substratbreite beträgt.

13. Vorrichtung nach Anspruch 11 oder Anspruch 12, **dadurch gekennzeichnet, dass** entlang der Durchlaufbahn gesehen vor der mindestens einen Auftragvorrichtung ein jeweiliger Substrat-Sensor vorgesehen ist zum Erkennen eines heran bewegten Substrates sowie zum Erkennen eines vorbei bewegten Substrates, insbesondere ein optischer Substrat-Sensor.

## Claims

1. Method for treating a substrate surface of a flat substrate with a process medium at the substrate underside, wherein the process medium has a removing or etching effect on the substrate surface, and wherein the substrates lying horizontally are wetted with the process medium from below and, using at least one application device, the upwardly facing substrate top side is wetted or covered with water or a corresponding protective liquid over a large area or over the whole area as protection against the process medium or the outgassings thereof acting on or reaching the substrate top side,
**characterized in that**
- the protective liquid is applied to the substrate top side before the substrate underside is wetted with the process medium, in particular before the substrate is moved over a tank with the process medium therein, and/or
- the protective liquid is applied to the substrate top side controlled in such a manner that it is applied exclusively to the substrate top side by starting the application only when a substrate is situated under an application device, and by stopping when the substrate is still situated under the application device.

2. Method according to Claim 1, **characterized in that** the protective liquid is applied to the substrate top sides in a continuous method.

3. Method according to Claim 1 or Claim 2, **characterized in that** the protective liquid is applied multiple times, with time intervals inbetween, to the substrate top side.

4. Method according to Claim 1 or Claim 2, **characterized in that** the protective liquid is applied one single time to the substrate top side.

5. Method according to any of the preceding claims, **characterized in that** the position or location of an adducted substrate is detected using substrate sensors and the application device is controlled depending on this.

6. Method according to any of the preceding claims, **characterized in that**
- the protective liquid is applied to the substrate top side with a two-dimensionally distributed profile, in particular by means of spray nozzles designed for producing a two-dimensionally distributed spray mist, or
- the protective liquid is applied to the substrate top side in a punctiform fashion, for the purpose of subsequent flowing, in order to cover the substrate surface over a large area or over the whole area.

7. Method according to any of the preceding claims, **characterized in that**
- the substrate underside touches a liquid level of process medium in a tank with the process medium therein, without deeper immersion of the substrates, and/or
- the substrates are rinsed after the treatment with the process medium, in particular the protective liquid is also rinsed or removed from the substrate top side.

8. Method according to any of the preceding claims, **characterized in that** the protective liquid has a higher viscosity than water, and in particular is PEG or phosphoric acid.

9. Method according to any of the preceding claims, **characterized in that** substrates are treated which are pierced or have perforations, wherein preferably a protective liquid according to Claim 8 having a higher viscosity than water is used.

10. Method according to any of the preceding claims, **characterized in that** several application devices are arranged one next to the other in a direction approximately transverse to the continuous-passage path of the substrates and the substrates are brought in rows one after the other onto the continuous-passage path and, in each case, pass exactly beneath one application device.

11. Device for carrying out the method according to any of the preceding claims, wherein above a continuous-passage path for substrates which are transported for the treatment of the substrate underside with a process medium over a tank with the process medium therein, at least one application device is provided for applying water or protective liquid to the upwardly facing substrate top side, **characterized in that** at least one application device is arranged upstream of the tank with the process medium therein.

12. Device according to Claim 11, **characterized in that** a row of application devices is provided transverse to the continuous-passage path of the substrates with application devices being distanced one from the other, wherein in particular their distance is at least one width of a substrate.

13. Device according to Claim 11 or Claim 12, **characterized in that**, seen along the continuous-passage path of the substrates, a respective substrate sensor is provided upstream of the at least one application device for detection of a substrate being moved closer as well as for detection of a substrate moved in passing by, in particular an optical substrate sensor.

## Revendications

1. Procédé de traitement d'une surface d'un substrat sur un substrat plat avec un médium de processus sur la partie inférieure du substrat, dans lequel le médium de processus a un effet enlevant ou décapant sur la surface du substrat, et dans lequel les substrats situés horizontalement sont mouillés du dessous avec du médium de processus et la partie supérieure du substrat orientée vers le haut est mouillée avec ou recouvert d'eau ou un liquide de protection correspondant sur une grande superficie ou toute la superficie en utilisant au moins un dispositif d'application pour la protection contre une action ou un accès du médium de processus ou de ses dégazages sur la partie supérieure du substrat,
**caractérisé en ce que**
- le liquide de protection est apporté à la partie supérieure du substrat avant de mouiller la partie inférieure du substrat avec du médium de processus, en particulier avant d'avancer le substrat au-dessus d'un bassin contenant le médium de processus, et/ou
- le liquide de protection est appliqué sur la partie supérieure du substrat contrôlé de telle manière que le liquide est appliqué exclusivement sur la partie supérieure du substrat en commençant l'application pas avant qu'un substrat se trouve en dessous d'un dispositif d'application et en arrêtant quand le substrat se trouve encore en dessous du dispositif d'application.

2. Procédé selon la revendication 1, **caractérisé en ce que** l'on applique le liquide de protection sur les parties supérieures du substrat dans un procédé en continu.

3. Procédé selon la revendication 1 ou la revendication 2, **caractérisé en ce que** l'on applique le liquide de protection sur la partie supérieure du substrat à plusieurs reprises avec des intervalles de temps.

4. Procédé selon la revendication 1 ou la revendication 2, **caractérisé en ce que** l'on applique le liquide de protection sur la partie supérieure du substrat une seule fois.

5. Procédé selon l'une quelconque des revendications précédentes, **caractérisé en ce que** la position ou la localisation d'un substrat approché est déterminée au moyen de capteurs de substrat et le dispositif d'application est commandé en fonction de cela.

6. Procédé selon l'une quelconque des revendications précédentes, **caractérisé en ce que**
- l'on applique le liquide de protection sur la partie supérieure du substrat avec un profil de distribution étendu, en particulier au moyen de buses de pulvérisation, qui sont conçues pour la génération d'un brouillard pulvérisé de distribution étendue ou
- l'on applique le liquide de protection sur la partie supérieure du substrat ponctuellement pour que le liquide s'égaille ultérieurement afin de recouvrir une grande superficie ou toute la superficie de la surface du substrat.

7. Procédé selon l'une quelconque des revendications précédentes, **caractérisé en ce que**
- la partie inférieure du substrat fait contact avec un niveau de liquide de médium de processus dans un bassin contenant le médium de processus sans immersion profonde des substrats et/ou
- l'on rince les substrats après le traitement avec le médium de processus, en particulier l'on rince ou enlève aussi le liquide de protection de la partie supérieure du substrat.

8. Procédé selon l'une quelconque des revendications précédentes, **caractérisé en ce que** le liquide de protection présente une viscosité supérieure à celle de l'eau, en particulier le liquide est du PEG ou de l'acide phosphorique.

9. Procédé selon l'une quelconque des revendications précédentes, **caractérisé en ce que** des substrats perforés ou présentant des percées sont traités, dans lequel est utilisé de préférence un liquide de protection selon la revendication 8 présentant une viscosité supérieure à celle de l'eau.

10. Procédé selon l'une quelconque des revendications précédentes, **caractérisé en ce que** plusieurs dispositifs d'application sont agencés côte à côte dans une direction à peu près transversalement par rapport à la voie de passage des substrats et les substrats sont amenés successivement en rangées sur la voie de passage et chacun passe exactement en dessous d'un dispositif d'application.

11. Dispositif pour la mise en oeuvre du procédé selon l'une quelconque des revendications précédentes, dans lequel au-dessus d'une voie de passage pour substrats, étant transportés pour traiter la partie inférieure du substrat avec un médium de processus au-dessus d'un bassin contenant le médium de processus, au moins un dispositif d'application est prévu pour appliquer de l'eau ou un liquide de protection sur la partie supérieure du substrat orientée vers le haut, **caractérisé en ce qu'**au moins un dispositif d'application est arrangé en amont du bassin contenant le médium de processus.

12. Dispositif selon la revendication 11, **caractérisé en ce qu'**une série de dispositifs d'application est prévue transversalement par rapport à la voie de passage pour les substrats avec des dispositifs d'application espacés l'un de l'autre, dans lequel en particulier l'écart est au moins une largeur de substrat.

13. Dispositif selon la revendication 11 ou la revendication 12, **caractérisé en ce que**, vu le long de la voie de passage, en amont de l'au moins un dispositif d'application un capteur de substrat respectif est prévu pour détecter un substrat approchant ainsi que pour détecter un substrat passant, en particulier un capteur de substrat optique.
